(19) Europäisches Patentamt / European Patent Office / Office européen des brevets

(11) **EP 2 226 913 B1**

(12) **EUROPÄISCHE PATENTSCHRIFT**

(45) Veröffentlichungstag und Bekanntmachung des Hinweises auf die Patenterteilung:
**04.01.2012 Patentblatt 2012/01**

(51) Int Cl.:
***H02H 3/16*** *(2006.01)*

(21) Anmeldenummer: **10075133.8**

(22) Anmeldetag: **14.02.2006**

(54) **Verfahren zum Erkennen eines Erdschlusses in einem gelöschten oder gegenüber Erdpotential isolierten dreiphasigen Energieübertragungsnetz**

Method for earth fault detection in a three-phase energy transmission network with compensated or isolated neutral.

Procédé de detection d'un défaut à terre dans un réseau de distribution électrique triphasé isolé ou compensé par rapport au potentiel de terre.

(84) Benannte Vertragsstaaten:
**AT BE BG CH CY CZ DE DK EE ES FI FR GB GR HU IE IS IT LI LT LU LV MC NL PL PT RO SE SI SK TR**

(43) Veröffentlichungstag der Anmeldung:
**08.09.2010 Patentblatt 2010/36**

(62) Dokumentnummer(n) der früheren Anmeldung(en) nach Art. 76 EPÜ:
**06722503.7 / 1 984 995**

(73) Patentinhaber: **Siemens Aktiengesellschaft**
**80333 München (DE)**

(72) Erfinder:
• **Claus, Michael**
  **90482 Nürnberg (DE)**
• **Kereit, Matthias**
  **12159 Berlin (DE)**
• **Steynberg, Gustav**
  **91338 Igensdorf (DE)**

(56) Entgegenhaltungen:
**JP-A- 2004 015 862     US-A1- 2004 021 995**

**Beschreibung**

Die Erfindung bezieht sich auf ein Verfahren mit den Merkmalen gemäß dem Oberbegriff des Anspruchs 1. Unter einem isolierten dreiphasigen Energieübertragungsnetz ist ein dreiphasiges Netz zu verstehen, bei dem der Sternpunkt des Netzes gegenüber dem Erdpotential isoliert ist. Unter einem gelöschten dreiphasigen Energieübertragungsnetz ist ein "kompensiertes" dreiphasiges Netz zu verstehen, bei dem der Sternpunkt des Energieübertragungsnetzes mit dem Erdpotential über eine Erdschlusslöschspule (z. B. Petersenspule) verbunden ist.

Ein solches Verfahren ist z. B. aus der JP 2004 015862 A bekannt. Die JP 2004 015862 A beschreibt ein Verfahren zum Erkennen einer fehlerbehafteten Phase, insbesondere bei Mehrfacherdschlüssen in hochohmig geerdeten Netzen, bei dem ein Erdschlussüberspannungsrelais bei Erkennung eines Erdschlusses zunächst eine vorgegebene Zeitdauer abwartet, bis ein Fehlersignal erzeugt wird, das zur weiteren Erkennung einer fehlerbehafteten Phase genutzt wird.

Der Erfindung liegt die Aufgabe zugrunde, ein Verfahren der eingangs genannten Art noch zuverlässiger auszugestalten.

Diese Aufgabe wird erfindungsgemäß dadurch gelöst, dass überprüft wird, ob die verketteten Phasenspannungen des Energieübertragungsnetzes relativ zueinander eine vorgegebene amplitudenbezogene Unsymmetrie-Schwelle überschreiten, dass ein entsprechendes Symmetriesignal gebildet wird, das eine Symmetrie oder Unsymmetrie anzeigt, und dass dieses Symmetriesignal bei der weiteren Überwachung herangezogen wird.

Das erfindungsgemäße Verfahren geht von der erfinderseitigen Erkenntnis aus, dass bei Doppelerdschlüssen mit räumlich weit voneinander getrennten Kurzschlussstellen der auftretende Erdstrom mitunter zu klein ist und damit allein einen Doppelerdschluss nicht in allen Fällen zuverlässig signalisieren kann. Erfindungsgemäß wird daher u. a. zum Erkennen eines Doppelerdschlusses ein anderes oder zumindest weiteres Kriterium vorgeschlagen, das von dem Erdstrom unabhängig ist. Konkret sieht die Erfindung vor, zumindest auch die verketteten Phasenspannungen zum Erkennen eines Fehlers heranzuziehen und ein entsprechendes Symmetriesignal zu bilden. Das Symmetriesignal kann zum Blockieren eines Fehlersignals bei Einfach-Erdschlusswischern (kurzzeitige Einfach-Erdschlüsse) verwendet werden.

Wenn ein Einphasen-Erdschluss detektiert wird, wird bevorzugt für eine vorgegebene Zeitdauer zunächst ein Sperrsignal erzeugt, das eine Ausgabe des Fehlersignals für diese Zeitdauer blockiert. Durch eine solche Vorgehensweise wird in vorteilhafter Weise verhindert, dass kurzzeitige "Erdschlusswischer" (also kurze Erdschlüsse) ein Abschalten von Leitungen oder sonstiges Reaktionen außerhalb des Schutzgerätes auslösen können. Beispielsweise wird bei einem solchen Verfahren ein Zeitglied eingesetzt.

Besonders bevorzugt kommt es zu einer solchen Blockierung jedoch nur dann, wenn die verketteten Phasenspannungen die Unsymmetrie-Schwelle unterschreiten bzw. das entsprechende Symmetriesignal eine Symmetrie der verketteten Phasenspannungen anzeigt.

Besonders bevorzugt wird zusätzlich überprüft, ob die Nullspannung des Energieübertragungsnetzes einen vorgegebenen Nullspannungs-Schwellenwert überschreitet. Ist dies der Fall und überschreiten die verketteten Phasenspannungen des Energieübertragungsnetzes relativ zueinander die vorgegebene amplitudenbezogene Unsymmetrie-Schwelle, so wird ein Anregesignal erzeugt, das auf die Möglichkeit bzw. die hohe Wahrscheinlichkeit hinweist, dass ein Erdfehler vorliegt. Das Anregesignal kann beispielsweise als Triggersignal für weitere Untersuchungen herangezogen werden.

Vorzugsweise wird zusätzlich auch der Nullstrom gemessen und das Anregesignal zusätzlich auch dann erzeugt, wenn der Nullstrom einen vorgegebenen Nullstrom-Schwellenwert überschreitet.

Besonders einfach und damit vorteilhaft lässt sich eine Unsymmetrie der verketteten Spannungen feststellen, indem die Amplituden der drei verketteten Phasenspannungen bestimmt werden und indem die vorgegebene amplitudenbezogene Unsymmetrie-Schwelle als überschritten angesehen wird, wenn die Differenz zwischen der größten Amplitude und der kleinsten Amplitude eine vorgegebene Differenzschwelle überschreitet.

Gemäß einer bevorzugten Ausgestaltung des Verfahrens ist vorgesehen, dass geprüft wird, ob eine Stromwandlersättigung bezüglich zumindest eines Phasenleiterstrommesswerts aufgetreten ist, und dass im Falle einer Stromwandlersättigung das Erzeugen des Anregesignals unterdrückt wird, sofern ausschließlich das Überschreiten des Nullstrom-Schwellenwerts durch den Nullstrom das Anregesignal auslösen würde.

Im Hinblick auf eine Anpassung des heranzuziehenden Schwellenwerts an die im Einzelfall vorliegende Belastung der Leitung wird es als vorteilhaft angesehen, wenn der vorgegebene Nullstrom-Schwellenwert eine variable Größe ist, die in Abhängigkeit von den Strommesswerten adaptiv verändert wird. Vorzugsweise wird der vorgegebene Nullstrom-Schwellenwert umso größer eingestellt, je größer die Strommesswerte sind. Beispielsweise kann der vorgegebene Nullstrom-Schwellenwert durch eine mathematische Funktion definiert werden, bei der die gemessenen Strommesswerte Parameter sind.

Die Erfindung wird nachfolgend anhand von Ausführungsbeispielen näher erläutert; dabei zeigen beispielhaft:

Figur 1     ein Ausführungsbeispiel für ein erfindungsgemäßes Schutzgerät;

Figur 2    ein Ausführungsbeispiel für eine Prüfeinrich-tung des Schutzgeräts gemäß Figur 1;

Figur 3    ein Ausführungsbeispiel für eine Symmetrie-Prüfeinrichtung der Prüfeinrichtung gemäß Figur 2;

Figur 4    ein Ausführungsbeispiel für eine Fehlersignal-Erzeugungseinrichtung des Schutzgeräts gemäß Figur 1;

Figur 5    ein Ausführungsbeispiel für eine Spannungszei- ger-Auswerteinrichtung der Fehlersignal-Erzeu- gungseinrichtung gemäß Figur 4;

Figur 6    ein Ausführungsbeispiel für eine Schleifenim-pedanz-Auswerteinrichtung der Feh- lersi-gnal-Erzeugungseinrichtung gemäß Figur 4;

Figur 7    beispielhaft einen Impedanz-Anregebereich in der komplexen Ebene;

Figur 8    beispielhaft, wie Leiter-Erde-Spannungszei-ger und verkettete Spannungszeiger im fehlerfreien Zustand, im Falle eines Einfach-Erdschlusses (z. B. Phasenleiter L2 betroffen) oder im Falle eines Doppelerdschlusses (z. B. Phasen- leiter L1 und L2 betroffen) aussehen können; und

Figur 9    beispielhaft eine Anordnung mit zwei Schutzgeräten und deren Betrieb.

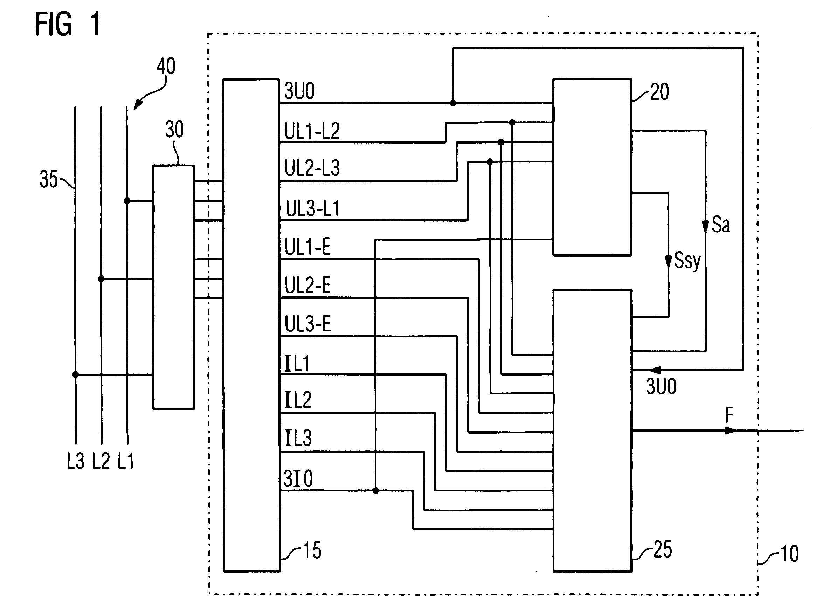

In der Figur 1 ist ein Ausführungsbeispiel für ein erfindungsgemäßes Schutzgerät 10 dargestellt. Das Schutzgerät 10 weist zur Erkennung eines Doppelerdschlusses eingansseitig eine Umrechnungseinrichtung 15 auf, die mit einer Prüfeinrichtung 20 sowie mit einer Fehlersignal-Erzeugungseinrichtung 25 in Verbindung steht. Die Umrechnungseinrichtung 15 ist über eine externe Wandlereinheit 30 mit einer Energieübertragungsleitung 35 eines gelöschten oder gegenüber Erdpotential isolierten dreiphasigen Energieübertragungsnetzes 40 verbunden.

Die Wandlereinheit 30 misst die in der Energieübertragungsleitung 35 fließenden Ströme sowie die entsprechenden Leitererdespannungen der Phasenleiter der Energieübertragungsleitung 35 und erzeugt ausgangsseitig entsprechende Messgrößen, die zur Umrechnungseinrichtung 15 gelangen und von dieser weiterverarbeitet werden. Die Umrechnungseinrichtung 15 erzeugt mit den von der Wandlereinheit 30 gebildeten Messgrößen ausgangsseitig Spannungs- und Strommesswerte, und zwar Leitererdespannungsmesswerte UL1-E, UL2-E und UL3-E sowie verkettete Spannungen UL1-L2, UL2-L3 und UL3-L1 und Phasenstrommesswerte IL1, IL2 und IL3. Außerdem erzeugt die Wandlereinheit 30 einen Messwert für die Nullspannung 3U0 der Energieübertragungsleitung 35 sowie einen Messwert für den Nullstrom 3I0. Die Messwerte für den Nullstrom, die Nullspannung sowie die verketteten Spannungen werden wie folgt gebildet:

$$\underline{3U0} \; = \; \underline{UL1\text{-}E} \; + \; \underline{UL2\text{-}E} \; + \; \underline{UL3\text{-}E}$$

$$\underline{3I0} \; = \; \underline{IL1} \; + \; \underline{IL2} \; + \; \underline{IL3}$$

$$\underline{UL1\text{-}L2} \; = \; \underline{UL1\text{-}E} \; - \; \underline{UL2\text{-}E}$$

$$\underline{UL3\text{-}L2} \; = \; \underline{UL3\text{-}E} \; - \; \underline{UL2\text{-}E}$$

$$\underline{UL1\text{-}L3} \; = \; \underline{UL1\text{-}E} \; - \; \underline{UL3\text{-}E}$$

$\underline{IL1}$, $\underline{IL2}$, $\underline{IL3}$, $\underline{UL1\text{-}L2}$, $\underline{UL2\text{-}L3}$, $\underline{UL3\text{-}L1}$, $\underline{UL1\text{-}E}$, $\underline{UL2\text{-}E}$, $\underline{UL3\text{-}E}$ bezeichnen die Messwerte in komplexer Zeigerform.

Die entsprechenden Messwerte gelangen - wie in der Figur 1 gezeigt - zu der Prüfeinrichtung 20 und zu der Fehlersignal-Erzeugungseinrichtung 25. Die Aufgabe der Prüfeinrichtung 20 besteht darin, mit den eingangsseitig anliegenden Messwerten ein Anregesignal Sa sowie ein Symmetriesignal Ssy zu erzeugen.

Das Anregesignal Sa gibt an, dass in dem Energieübertragungsnetz 40 womöglich ein Erdschluss aufgetreten ist. Das Symmetriesignal Ssy zeigt an, dass die verketteten Phasenspannungen UL1-L2, UL2-L3 und UL3-L1 symmetrisch oder unsymmetrisch zueinander sind. Von einer Unsymmetrie wird ausgegangen, wenn die verketteten Phasenspannungen UL1-L2, UL2-L3 und UL3-L1 relativ zueinander eine vorgegebene amplitudenbezogene Unsymmetrieschwelle überschreiten.

Die ausgangsseitig von der Prüfeinrichtung 20 erzeugten Signale, nämlich das Anregesignal Sa sowie das Symmetriesignal Ssy, gelangen zu der Fehlersignal-Erzeugungseinrichtung 25, die diese Signale weiterverarbeitet. Die Funktion der Fehlersignal-Erzeugungseinrichtung 25 besteht darin, im Falle eines Erdschlusses zu ermitteln, welche der Phasenleiter der Energieüber-tragungsleitung 35 bzw. des Energieübertragungsnet-zes 40 von dem Erdschluss betroffen sind, und ausgangsseitig ein entsprechendes Fehlersignal F zu erzeugen, das die entsprechenden Phasenleiter identifiziert.

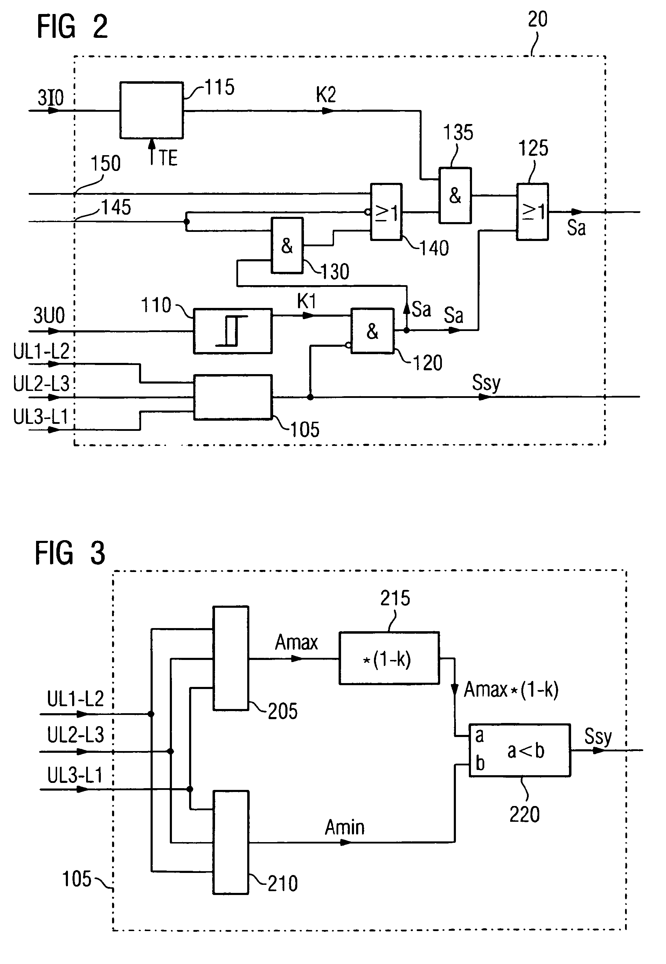

In der Figur 2 ist ein Ausführungsbeispiel für die Prüfeinrichtung 20 gemäß Figur 1 dargestellt. Man erkennt eingangsseitig eine Symmetrie-Prüfeinrichtung 105, an der eingangsseitig die verketteten Spannungen UL1-L2, UL2-L3 und UL3-L1 anliegen. Die Symmetrie-Prüfeinrichtung 105 prüft, ob die eingangsseitig anliegenden verketteten Phasenspannungen symmetrisch zueinander sind und erzeugt ausgangsseitig im Falle einer Symmetrie das Symmetriesignal Ssy mit einer logischen 1 und im Falle einer Unsymmetrie mit einer logischen 0.

Die Prüfeinrichtung 20 ist darüber hinaus mit einem Nullspannungskomparator 110 ausgestattet, der die anliegende Nullspannung 3U0 mit einem vorgegebenen Nullspannungsschwellenwert vergleicht und ausgangsseitig ein Vergleichssignal K1 erzeugt, wenn die Amplitude der eingangsseitig anliegenden Nullspannung den vorgegebenen Nullspannungsschwellenwert überschreitet. Weist das Vergleichssignal K1 eine logische 1 auf und sind die verketteten Phasenspannungen außerdem unsymmetrisch zueinander (Ssy = "0"), so erzeugt das UND-Glied 120, an dessen invertierendem Eingang das Symmetriesignal Ssy anliegt, ausgangsseitig eine logische 1, die von dem ODER-Glied 125 als Anregesignal Sa weitergeleitet wird.

Die Prüfeinrichtung 20 ist darüber hinaus mit einer Nullstrom-Überwachungseinrichtung 115 ausgestattet, die den eingangsseitig anliegenden Nullstrom mit einem einstellbaren Nullstrom-Schwellenwert vergleicht. Überschreitet der eingangsseitig anliegende Nullstrom 3I0 diesen Schwellenwert, so wird ausgangsseitig ein zweites Vergleichssignal K2 mit einer logischen "1" erzeugt. Die Nullstrom-Überwachungseinrichtung 115 kann über ein Stellsignal TE von außen eingestellt werden, beispielsweise in Abhängigkeit von der Größe der in den Phasenleitern der Energieübertragungsleitung 35 fließenden Phasenströme.

In der Figur 2 erkennt man außerdem ein UND-Glied 120 sowie ein ODER-Glied 125, die hintereinander geschaltet sind und eingangsseitig mit der Symmetrie-Prüfeinrichtung 105 sowie dem Nullspannungskomparator 110 in Verbindung stehen. Das ODER-Glied 125 gibt ausgangsseitig das Anregesignal Sa mit einer logischen 1 ab, sofern der Nullspannungskomparator 110 feststellt, dass die eingangsseitig anliegende Nullspannung 3U0 den vorgegebenen Nullspannungsschwellenwert überschreitet, und sofern zusätzlich die Symmetrie-Prüfeinrichtung 105 feststellt, dass die eingangsseitig anliegenden verketteten Phasenspannungen unsymmetrisch zueinander sind.

Wird von dem UND-Glied 120 ausgangsseitig eine logische 0 erzeugt, so kann das ODER-Glied 125 ausgangsseitig trotzdem eine logische 1 als Anregesignal Sa abgeben, wenn die Nullstrom-Überwachungseinrichtung 115 feststellt, dass der Nullstrom 3I0 den vorgegebenen Nullstrom-Schwellenwert überschreitet und das entsprechende zweite Vergleichssignal K2 mit einer logischen 1 erzeugt.

In der Figur 2 erkennt man außerdem weitere UND-Glieder 130 und 135 sowie ein zusätzliches ODER-Glied 140. Die Funktion dieser drei Komponenten besteht darin, die Abgabe des zweiten Vergleichssignals K2 der Nullstrom-Überwachungseinrichtung 115 als Anregesignal Sa zu blockieren. Liegt nämlich an einem Stromwandler-Sättigungseingang 145 der Prüfeinrichtung 20 ein Signal mit einer logischen 1 an, das auf eine Stromwandlersättigung hindeutet, so lässt sich über das weitere UND-Glied 130, das ODER-Glied 140, an dessen invertierenden Eingang das Signal vom Stromwandler-Sättigungseingang 145 geleitet wird, sowie das weitere UND-Glied 135 verhindern, dass bei Vorliegen einer logischen 1 beim zweiten Vergleichssignal K2 ausgangsseitig ein Anregesignal Sa mit einer logischen 1 erzeugt wird.

Die Verschaltung der beiden UND-Glieder 130 und 135 sowie des ODER-Glieds 140 ermöglicht es darüber hinaus, den Stromwandler-Sättigungseingang 145 zu deaktivieren, indem an einem entsprechenden Eingang 150 der Prüfeinrichtung 20 ein Signal mit einer logischen 1 angelegt wird. Liegt nämlich am Eingang 150 eine logische 1 an, so wird der Ausgang des weiteren ODER-Gliedes 140 stets eine logische 1 aufweisen, so dass eine eventuell von der Nullstrom-Überwachungseinrichtung 115 erzeugte logische 1 im zweiten Vergleichssignal K2 stets an den Ausgang des ODER-Gliedes 125 durchgeschaltet wird, wodurch am Ausgang der Prüfeinrichtung 20 das Anregesignal Sa mit einer logischen 1 erzeugt wird.

In der Figur 3 ist ein Ausführungsbeispiel für die Symmetrie-Prüfeinrichtung 105 der Prüfeinrichtung 20 gemäß Figur 2 dargestellt. Man erkennt, dass die Symmetrie-Prüfeinrichtung 105 eingangsseitig zwei Vergleichsbausteine 205 und 210 aufweist. Bei dem Vergleichsbaustein 205 handelt es sich um einen Baustein, der die maximalen Amplituden der drei verketteten Phasenspannungen, die eingangsseitig an der Symmetrie-Prüfeinrichtung 105 anliegen, bestimmt und ausgangsseitig einen Maximalamplitudenwert Amax erzeugt, der die Amplitudenhöhe derjenigen Amplitude angibt, die von den drei verketteten Phasenspannungen die größte ist.

In entsprechender Weise arbeitet der Vergleichsbaustein 210, der jedoch von den drei eingangsseitig anliegenden verketteten Phasenspannungen diejenige Amplitude bestimmt, die am kleinsten ist. Ausgangsseitig erzeugt der Vergleichsbaustein 210 einen Wert Amin für die minimale Amplitude.

Dem Vergleichsbaustein 205 nachgeordnet ist eine Multipliziereinrichtung 215, die den Wert Amax für die maximale Amplitude mit einem Korrekturfaktor (1-k) multipliziert. K beträgt beispielsweise 2 %, so dass also der Wert für die maximale Amplitude Amax in diesem Beispielfall mit einem Wert von 0,98 multipliziert wird.

Der Ausgangswert der Multipliziereinrichtung 215 sowie der Wert Amin für die minimale Amplitude gelangen zu einem Komparator 220, der die beiden eingangsseitig anliegenden Werte miteinander vergleicht und ausgangsseitig das Symmetriesignal Ssy mit einer logischen 1 erzeugt, wenn der Wert Amax*(1-k) kleiner ist als der Wert Amin für die Minimalamplitude, was bedeutet, dass die maximale Amplitude und die minimale Amplitude relativ ähnlich sind und somit eine "Symmetrie" der verketteten Leiter-Erde-Spannungen vorliegt. In entsprechender Weise erzeugt der Komparator 220 das Symmetriesignal Ssy mit einer logischen 0 dann, wenn das Produkt Amax*(1-k) den Wert Amin für die minimale Amplitude überschreitet: Überschreitet nämlich das Produkt Amax*(1-k) den Wert Amin, so bedeutet dies anschaulich, dass die maximale Amplitude Amax sehr viel größer (zumindest mehr als 2% größer) ist als die minimale Amplitude Amin und somit eine "Unsymmetrie" der verketteten Leiter-Erde-Spannungen vorliegt.

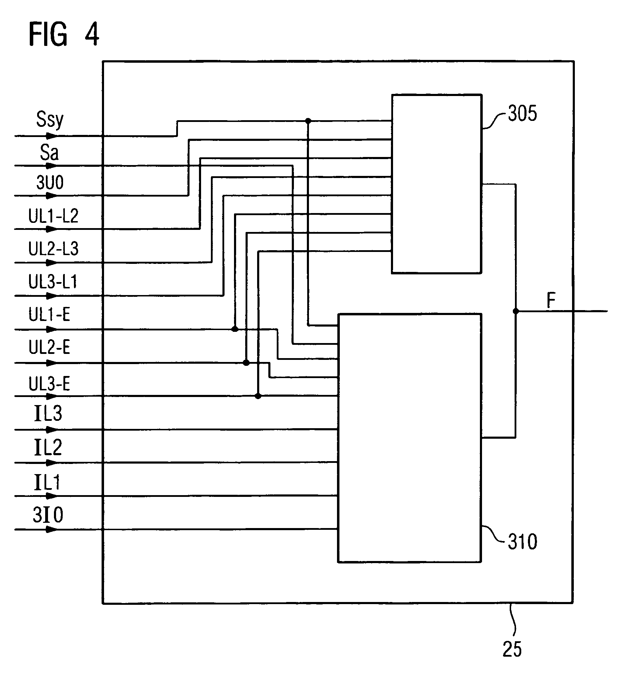

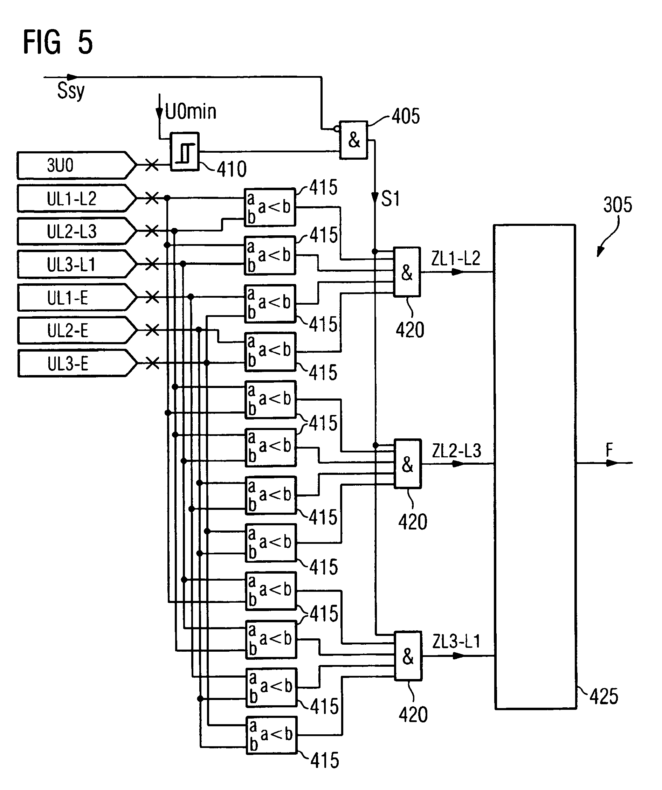

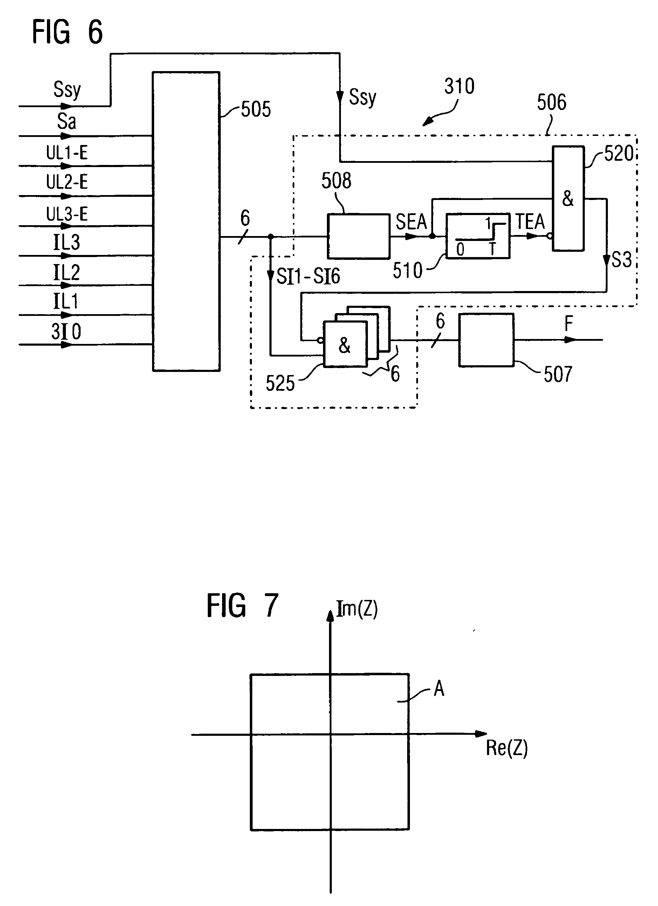

In der Figur 4 ist ein Ausführungsbeispiel für die Fehlersignal-Erzeugungseinrichtung 25 gemäß Figur 1 dargestellt. Man erkennt, dass die Fehlersignal-Erzeugungseinrichtung eine Spannungszeiger-Auswerteinrichtung 305 sowie eine Schleifenimpedanz-Auswerteinrichtung 310 aufweist. Die Spannungszeiger-Auswerteinrichtung 305 sowie die Schleifenimpedanz-Auswerteinrichtung 310 sind jeweils eingangsseitig mit dem Symmetriesignal Ssy der Prüfeinrichtung 20 beaufschlagt und arbeiten parallel. Die Aktivierung der beiden Einrichtungen 305 und 310 wird näher im Zusammenhang mit den Figuren 5 und 6 erläutert.

In der Figur 5 ist ein Ausführungsbeispiel für die Spannungszeiger-Auswerteinrichtung 305 gemäß Figur 4 dargestellt. Man erkennt ein UND-Glied 405, das eingangsseitig mit dem Symmetriesignal Ssy beaufschlagt ist. Das UND-Glied 405 erzeugt ausgangsseitig eine logische 1, wenn das Symmetriessignal Ssy eine logische 0 aufweist und wenn gleichzeitig die Nullspannung 3U0 den vorgegebenen Nullspannungsschwellwert U0min überschreitet; letzteres wird durch einen Komparator 410 festgestellt.

Bei dem Ausführungsbeispiel gemäß Figur 5 bilden das UND-Glied 405 sowie der Komparator 410 Bestandteile der Spannungszeiger-Auswerteinrichtung 305, um ein Aktivierungssignal S1 für die Spannungszeiger-Auswerteinrichtung 305 zu bilden. Im Hinblick auf eine minimale Teilezahl innerhalb des Schutzgerätes 10 können diese beiden Komponenten, also das UND-Glied 405 sowie der Komparator 410 auch weggelassen werden und es kann stattdessen das Ausgangssignal des UND-Gliedes 120 der Prüfeinrichtung 20 gemäß Figur 2 verwendet und als Aktivierungssignal S1 in die Spannungszeiger-Auswerteinrichtung 305 eingespeist werden.

Das Aktivierungssignal S1 entspricht im Übrigen dem Anregesignal Sa gemäß der Figur 2 für den Fall einer Unsymmetrie der verketteten Phasenspannungen. Das Aktivierungssignal S1 gemäß der Figur 5 sowie das Ausgangssignal des UND-Gliedes 120 bilden somit selbständig bzw. auch allein Anregesignale im Sinne der obigen Erläuterungen zu vorteilhaften Ausgestaltungen der Erfindung.

Wie sich in der Figur 5 darüber hinaus erkennen lässt, weist die Spannungszeiger-Auswerteinrichtung 305 insgesamt zwölf Komparatoren 415 auf, die in der in der Figur 5 dargestellten Weise mit den verketteten Phasenspannungen UL1-L2, UL2-L3 und UL3-L1 sowie den Leitererdespannungen UL1-E, UL2-E und UL3-E beaufschlagt sind. Je nach dem, wie die Spannungsverhältnisse am Eingang der Spannungszeiger-Auswerteinrichtung 305 konkret aussehen, gelangen entsprechende Auswertsignale zu insgesamt drei nachgeschalteten UND-Gliedern 420, die jeweils mit insgesamt vier der Komparatoren 415 verbunden sind. Die Ausgangssignale ZL1-L2, ZL2-L3 und ZL3-L1 geben durch eine logische 1 an, das sie einen bestimmten Fehlerzustand erkannt haben:

Weist das Ausgangssignal ZL1-L2 eine logische 1 auf, so sind die beiden Phasenleiter L1 und L2 des Energieversorgungsnetzes von einem Doppelerdschluss betroffen. Weist das Ausgangssignal ZL2-L3 eine logische 1 auf, so sind die beiden Phasenleiter L2 und L3 des Energieversorgungsnetzes von einem Doppelerdschluss betroffen; weist das Ausgangssignal ZL3-L1 eine logische 1 auf, so sind die beiden Phasenleiter L1 und L3 des Energieversorgungsnetzes von einem Doppelerdschluss betroffen.

Die Ausgangssignale ZL1-L2, ZL2-L3 und ZL3-L1 der nachgeschalteten UND-Glieder 420 gelangen zu einer Kodiereinrichtung 425, die die binären Ausgangssignale ZL1-L2, ZL2-L3 und ZL3-L1 zu dem digitalen Fehlersignal F umkodiert.

Zu einer Erzeugung des Fehlersignals F durch die Kodiereinrichtung 425 kann es dabei nur kommen, wenn durch das UND-Glied 405 bzw. durch das UND-Glied 120 gemäß Figur 2 das entsprechende Aktivierungssignal S1 mit einer logischen 1 für die drei UND-Glieder 420 erzeugt wird.

Anschaulich beschrieben funktioniert die Spannungszeiger-Auswerteinrichtung 305 derart, dass das Fehlersignal F anzeigt, welche der Phasenleiter L1, L2 bzw. L3 des Energieübertragungsnetzes 40 von dem Doppelerdschluss betroffen sind. Als fehlerbehaftete Phasenleiter erkennt die Spannungszeiger-Auswerteinrichtung 305 dabei diejenigen Phasenleiter, deren verkettete Spannung die kleinste Amplitude im Vergleich zu den beiden übrigen verketteten Spannungen aufweist und deren Phasenleiter-Erdespannungen amplitudenmäßig kleiner als die des nicht betroffenen Phasenleiters sind.

In der Figur 6 ist ein Ausführungsbeispiel für die Schleifenimpedanz-Auswerteinrichtung 310 gemäß Figur 4 dargestellt. Man erkennt eine Impedanz-Anregungseinrichtung 505, die eingangsseitig mit den Strom- und Spannungswerten der Umrechnungseinrichtung 15 gemäß Figur 1 beaufschlagt ist. Sofern am Eingang der Impedanz-Anregungseinrichtung 505 das Anregesignal Sa mit einer logischen 1 vorliegt, wertet die Impedanz-Anregungseinrichtung 505 die eingangsseitig anliegenden Strom- und Spannungswerte aus und erzeugt auf sechs signalindividuellen Leitungen (von denen in der Figur 6 der Übersichtlichkeit nur eine dargestellt ist) ausgangsseitig für jede angeregte Leiter-Erde-Schleife und jede angeregte Leiter-Leiter-Schleife ein binäres Signal SI1, SI2, ..., SI6 (z. B. SI1-SI3 für Leiter-Erde-Schleifen und SI4-SI6 für Leiter-Leiter-Schleifen) mit einer logischen 1 und für jede nichtangeregte Schleife ein entsprechendes Signal mit einer logischen 0. Unter einer angeregten Schleife ist in diesem Zusammenhang eine solche zu verstehen, bei der die Schleifenimpedanz innerhalb eines entsprechenden Impedanz-Anregebereichs A liegt. Die Figur 7 zeigt einen solchen Impedanz-Anregebereich beispielhaft in der komplexen Ebene.

Sofern am Eingang der Impedanz-Anregungseinrichtung 505 das Anregesignal Sa mit einer logischen 0 vorliegt, wertet die Impedanz-Anregungseinrichtung 505 die eingangsseitig anliegenden Strom- und Spannungswerte bezüglich des Vorliegens eines Erdschlusses hingegen nicht aus und erzeugt ausgangsseitig auch keine binären Signale SI1, SI2 oder SI3 bzw. nur solche mit einer logischen 0. Die Leiter-Leiter-Impedanzen werden unabhängig vom Anregesignal Sa beobachtet und ausgewertet.

Mit der Impedanz-Anregungseinrichtung 505 steht ausgangsseitig eine Einfach-Erdschlusswischer-Blockiereinrichtung 506 in Verbindung, der eine Impedanzsignal-Auswerteeinrichtung 507 nachgeordnet ist. Die Einfach-Erdschlusswischer-Blockiereinrichtung 506 weist u. a. eine eine Einphasen-Anregung erkennende Einrichtung 508, ein der Einrichtung 508 nachgeordnetes Zeitglied 510 sowie ein UND-Glied 520 auf.

Die eine Einphasen-Anregung erkennende Einrichtung 508 wertet die von der Impedanz-Anregungseinrichtung 505 gelieferten Signale SI1-SI6 aus und erzeugt ausgangsseitig ein binäres Signal SEA mit einer logischen 1, wenn keine der drei Leiter-Leiter-Schleifen (SI4 = SI5 = SI6 =0) angeregt ist und wenn von den drei Leiter-Erde-Schleifen genau eine einzige angeregt ist; eine solche Signalkonstellation deutet nämlich auf einen Einfach-Erdschluss hin. In allen anderen Fällen erzeugt die eine Einphasen-Anregung erkennende Einrichtung 508 ein Signal SEA mit einer logischen 0.

Wenn das Signal SEA von einer logischen 0 auf eine logische 1 übergeht, so erzeugt das Zeitglied 510 um eine Zeitdauer T von beispielsweise zwei Periodenlängen verzögert - bezogen auf die Nennfrequenz des Energieübertragungsnetzes 40 - ein entsprechendes Rechtecksignal TEA. Das Signal TEA weist eine logische 1 für eine vorgegebene Einschaltdauer Tein und eine logische 0 für den Zeitraum davor und danach auf und wird an das UND-Glied 520 weitergeleitet. Nach einer erfolgten Aktivierung des Zeitgliedes kann dieses für eine vorgegebene Zeitspanne T+Tein nicht erneut aktiviert werden; erst nach Ablauf der Spanne T+Tein ist ein Neustart möglich.

An dem UND-Glied 520 liegen somit das Symmetriesignal Ssy der Prüfeinrichtung 20, das Ausgangssignal SEA der Einrichtung 508 sowie das Rechtecksignal TEA an.

Das UND-Glied 520 erzeugt ausgangsseitig ein Sperrsignal S3 mit einer logischen 1 für ein nachgeordnetes UND-Glied 525, wenn das Symmetriesignal Ssy und das Ausgangssignal SEA eine logische 1 und das Rechtecksignal TEA eine logische 0 aufweisen. In diesem Falle, wenn also das Sperrsignal S3 eine logische 1 aufweist, wird das UND-Glied 525 gesperrt, so dass zur Impedanzsignal-Auswerteeinrichtung 507 keine Signale SI1, SI2, ..., SI6 gelangen können und diese auch kein Fehlersignal F erzeugt; es liegt also eine Blockierung vor.

Das UND-Glied 520 erzeugt hingegen ausgangsseitig ein Sperrsignal S3 mit einer logischen 0 für das nachgeordnete UND-Glied 525, wenn das Symmetriesignal Ssy oder das Ausgangssignal SEA eine logische 0 oder das Rechtecksignal TEA eine logische 1 aufweisen. In diesem Falle wird das UND-Glied 525 durchgeschaltet, so dass zur Impedanzsignal-Auswerteeinrichtung 507 alle Signale SI1, SI2, ..., SI6 gelangen können und die Impedanzsignal-Auswerteeinrichtung 507 das Fehlersignal F erzeugen kann.

Ist das UND-Glied 525 durchgeschaltet, erzeugt die Impedanzsignal-Auswerteeinrichtung 507 ein einen Doppelerdschluss kennzeichnendes Fehlersignal, wenn zwei Leiter-Erdeschleifen angeregt sind und die entsprechenden zwei Signale SI1 und SI2 bzw. SI2 und SI3 bzw. SI3 und SI1 eine logische 1 aufweisen; das Fehlersignal F kennzeichnet in diesem Falle die beiden Phasenleiter, deren Leiter-Erdeschleifen einen Doppelerdschluss aufweisen. Weist nur eine Leiter-Erdeschleife einen Kurzschluss auf, so kann dementsprechend ein Fehlersignal für einen Einfach-Erdschluss erzeugt werden, wobei das Fehlersignal den betreffenden Phasenleiter bezeichnet. Die Impedanzsignal-Auswerteeinrichtung 507 ist darüber hinaus in der Lage, Leiter-Leiter-Kurzschlüsse zu erkennen und ein entsprechendes Fehlersignal F zu erzeugen, wenn eine Leiter-Leiterschleife angeregt ist und das entsprechende Signal SI4, SI5 oder SI6 eine logische 1 aufweist.

Die Aufgabe der beschriebenen Einfach-Erdschlusswischer-Blockiereinrichtung 506 besteht im Falle eines Einfach-Erdschlusses darin, das Weiterleiten der Signale SI1, SI2 und SI3 zu blockieren, wenn nur kurzzeitige Einfach-Erdschlüsse - sogenannte Erdschlusswischer - auftreten. Im Falle eines Einfach-Erdschlusses bleibt nämlich aufgrund des Zeitgliedes 510 das UND-Glied 525 für die Zeitspanne T blockiert, sofern das Symmetriesignal Ssy eine logische 1 aufweist. Nur, wenn der Einfach-Erdschluss auch nach Ablauf der Zeitspanne T noch vorliegt (SEA=1, TEA=0), wird die Blockierung aufgehoben und die Signale SI1 bis SI3 können zur Impedanzsignal-Auswerteeinrichtung 507 gelangen. Liegt - wie dies im Falle eines Erdschlusswischers der Fall ist - nach Ablauf der Zeitspanne T kein Einfach-Erdschluss mehr vor (SEA=0, TEA=1), so wird die Blockierung aufgehoben, aber kein Fehlersignal für einen Einfach-Erdschluss erzeugt. Die Blockierung erfolgt dabei - wie erläutert - nur im Falle einer Symmetrie der verketteten Spannungen.

Wenn das Anregesignal Sa eine logische 1 aufweist und wenn keine Blockierung vorliegt, bildet die Schleifenimpedanz-Auswerteinrichtung 310 mit den eingangsseitig anliegenden Strom- und Spannungswerten die Schleifenimpedanzen der Energieübertragungsleitung 35 und vergleicht diese mit einem vorgegebenen Anregebereich. Liegen zwei Leiter-Erde-Schleifenimpedanzen innerhalb des vorgegebenen Anregebereichs, so schließt die Schleifenimpedanz-Auswerteinrichtung 310 darauf, dass die jeweiligen Phasenleiter vom Doppelerdschluss betroffen sind und erzeugt ausgangsseitig ein entsprechendes Fehlersignal F, das diese beiden Phasenleiter als vom Doppelerdschluss betroffen kennzeichnet.

Zusammenfassend ist somit festzustellen, dass die Spannungszeiger-Auswerteinrichtung 305 und die Schleifenimpedanz-Auswerteinrichtung 310 der Fehlersignal-Erzeugungseinrichtung 25 unterschiedlich arbeiten. Konkret erzeugt die Spannungszeiger-Auswerteinrichtung 305 ihr Fehlersignal, wenn die verketteten Phasenspannungen des Energieübertragungsnetzes relativ zueinander eine vorgegebene amplitudenbezogene Unsymmetrieschwelle überschreiten und die Nullspannung zu groß ist. In diesem Fall wird also das Fehlersignal F zur Kennzeichnung der vom Doppelerdschluss betroffenen Phasenleiter auf der Basis spannungsbezogener Messwerte gebildet. Die Bestimmung der fehlerbehafteten Phasenleiter erfolgt dabei wie im Zusammenhang mit der Figur 5 beschrieben. Sind die verketteten Phasenspannungen des Energieübertragungsnetzes 40 jedoch symmetrisch zueinander, so erfolgt die Ermittlung der vom Erdschluss betroffenen Phasenleiter in anderer Weise, nämlich auf der Basis der Schleifenimpedanzwerte, die sich bezüglich der Energieübertragungsleitung 35 aus den Strom- und Spannungsmesswerten errechnen lassen.

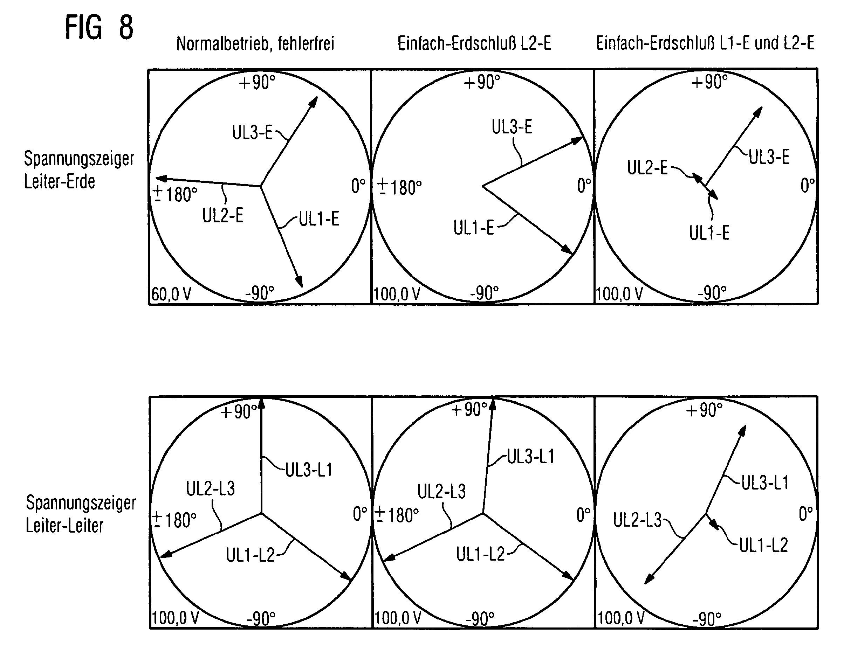

Die Figur 8 zeigt beispielhaft, wie Leiter-Erde-Spannungszeiger und verkettete Spannungszeiger im fehlerfreien Zustand, im Falle eines Einfach-Erdschlusses (z. B. Phasenleiter L2 betroffen) oder im Falle eines Doppelerdschlusses (z. B. Phasenleiter L1 und L2 betroffen) aussehen können. Man erkennt, dass im Falle eines Einfach-Erdschlusses die verketteten Spannungen noch symmetrisch sind und dass eine Unsymmetrie erst im Falle eines Doppel-Erdschlusses auftritt. Auch lässt sich erkennen, dass im Falle eines Einfach-Erdschlusses nur eine einzige Leiter-Erde-Spannung sehr klein wird und dass im Falle eines Doppelerdschlusses zwei Leiter-Erde-Spannungen gegenüber der nicht vom Erdschluss betroffenen Leiter-Erde-Spannung klein werden. Im letztgenannten Falle kommt es auch zu einer Erhöhung der Spannungsamplitude des "gesunden" Phasenleiters um den Faktor $\sqrt{3}$.

Die im Zusammenhang mit den Figuren 1 bis 6 gezeigten Funktionsblöcke des Schutzgerätes 10 können hardwaremäßig oder softwaremäßig realisiert sein, beispielsweise durch eine entsprechende Programmierung einer oder mehrerer Mikroprozessoranordnungen innerhalb des Schutzgerätes.

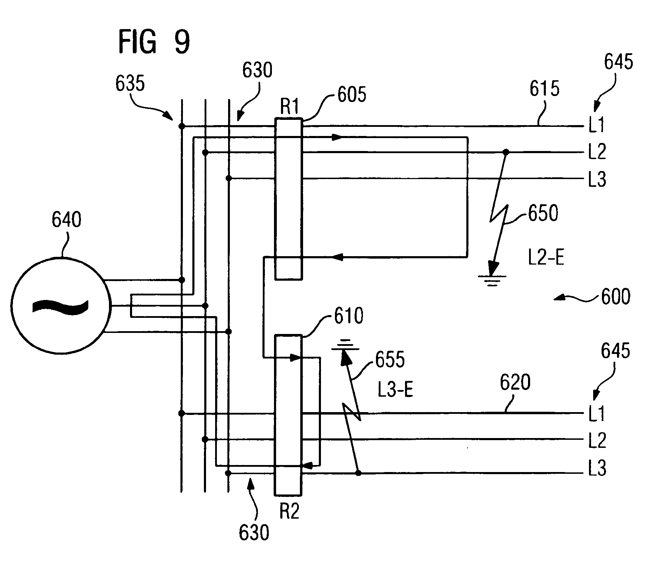

In der Figur 9 erkennt man eine Anordnung 600 mit zwei Schutzgeräten 605 und 610, beispielsweise solchen, wie sie im Zusammenhang mit den Figuren 1 bis 8 beschrieben sind.

Das erste Schutzgerät 605 ist an eine erste Stichleitung 615 und das zweite Schutzgerät 610 an eine zweite Stichleitung 620 angeschlossen. Die beiden Stichleitungen 615 und 620 gehören zu einem gelöschten oder gegenüber Erdpotential isolierten dreiphasigen Energieübertragungsnetz und sind mit ihrem einen Leitungsende 630 über eine Sammelschiene 635 miteinander sowie mit einem Generator 640 verbunden. An das jeweils andere Leitungsende 645 sind jeweils Verbraucher angeschlossen, die der Übersichtlichkeit halber in der Figur 9 nicht dargestellt sind.

Jedes der zwei Schutzgeräte 605 und 610 überwacht seine zugeordnete Stichleitung 615 bzw. 620 auf das Vorliegen eines Doppelerdschlusses, wie dies oben beschrieben wurde. Stellen die beiden Schutzgeräte unabhängig voneinander fest, dass ein Erdschluss 650 im Bereich der ersten Stichleitung 615 und ein weiterer Erdschluss 655 im Bereich der zweiten Stichleitung 620 aufgetreten ist, so prüfen sie, welche Phasen von dem Doppelerdschluss betroffen sind.

Sind, wovon in der Figur 9 beispielhaft ausgegangen wird, die Phasen L2 und L3 mit Erde verbunden, stellen dies also beide Schutzgeräte fest. In beiden Schutzgeräten ist, beispielsweise in einem elektronischen Speicher, hinterlegt, welche Phasen bevorzugt abzuschalten sind: Es gibt also eine bevorzugte Abschaltreihenfolge.

Unter der Annahme, dass in beiden Schutzgeräten hinterlegt ist, dass die Phase L1 vor den Phasen L2 und L3 und die Phase L2 vor der Phase L3 abgeschaltet werden soll, so wird nur das erste Schutzgerät 605 seine Stichleitung 615 abschalten; denn die Phase L2, die zu der Stichleitung 615 gehört, soll vor der Phase L3 abgeschaltet werden, die zu der Stichleitung 620 gehört.

Das zweite Schutzgerät 610 wird zunächst nichts unternehmen, da bei seiner Stichleitung 620 die Phase L3 von dem Erdschluss betroffen ist und nicht die Phase L2. Das zweite Schutzgerät wird somit eine vorgegebene Wartezeit abwarten, damit das erste Schutzgerät 605 den Doppelerdschluss abschalten kann. Sobald das erste Schutzgerät seine Stichleitung 615 abgeschaltet hat, liegt kein Doppelerdschluss mehr vor und die zweite Stichleitung kann trotz Erdschluss weiterbetrieben werden, weil die Stichleitungen zu einem zu einem gelöschten oder gegenüber Erdpotential isolierten dreiphasigen Energieübertragungsnetz gehören, das bei einphasigen Erdschlüssen durchaus weiterbetrieben werden kann.

Nur wenn das erste Schutzgerät 605 defekt ist und nichts unternimmt, wird das zweite Schutzgerät 610 nach Ablauf der vorgegebenen Wartezeit seine Stichleitung 615 abschalten.

**Patentansprüche**

1. Verfahren zum Überwachen eines gelöschten oder gegenüber Erdpotential isolierten dreiphasigen Energieübertragungsnetzes (40) im Hinblick auf das Vorliegen eines Erdschlusses, bei dem nach Detektion eines Einphasen-Erdschlusses für eine vorgegebene Zeitdauer (T) zunächst ein Sperrsignal erzeugt wird, das eine Ausgabe eines den Einphasen-Erdschluss angebenden Fehlersignals für diese Zeitdauer blockiert,
   **dadurch gekennzeichnet**,

   - überprüft wird, ob die verketteten Phasenspannungen des Energieübertragungsnetzes (40) relativ zueinander eine vorgegebene amplitudenbezogene Unsymmetrie-Schwelle überschreiten,
   - dass ein entsprechendes Symmetriesignal (Ssy) gebildet wird, das eine Symmetrie oder Unsymmetrie der verketteten Phasenspannungen anzeigt, und
   - dass dieses Symmetriesignal (Ssy) bei der weiteren Überwachung im Hinblick auf das Vorliegen eines Erdschlusses herangezogen wird.

2. Verfahren nach Anspruch 1,
   **dadurch gekennzeichnet,**

   - **dass** ein Blockieren der Ausgabe des Fehlersignals nur dann vorgenommen wird, wenn die verketteten Phasenspannungen die vorgegebene Unsymmetrie-Schwelle unterschreiten.

3. Verfahren nach Anspruch 1 oder 2,
   **dadurch gekennzeichnet,**

   - **dass** überprüft wird, ob die Nullspannung (3U0) des Energieübertragungsnetzes (40) einen vorgegebenen Nullspannungs-Schwellenwert (U0min) überschreitet, und
   - **dass** ein Anregesignal (Sa, S1) erzeugt wird, wenn die Nullspannung den Nullspannungs-Schwellenwert überschreitet und die verketteten Phasenspannungen die Unsymmetrie-Schwelle überschreiten.

4. Verfahren nach Anspruch 3,
   **dadurch gekennzeichnet,**

   - **dass** der Nullstrom (3I0) gemessen wird und das Anregesignal (Sa) zusätzlich auch dann erzeugt wird, wenn der Nullstrom (3I0) einen vorgegebenen Nullstrom-Schwellenwert überschreitet.

5. Verfahren nach einem der Ansprüche 1 bis 4,
   **dadurch gekennzeichnet,**

   - **dass** die Amplituden der drei verketteten Phasenspannungen bestimmt werden und dass die vorgegebene amplitudenbezogene Unsymmetrie-Schwelle als überschritten angesehen wird, wenn die Differenz zwischen der größten Amplitude (Amax) und der kleinsten Amplitude (Amin) eine vorgegebene Differenzschwelle überschreitet.

6. Verfahren nach einem der vorangehenden Ansprüche 4-5,
   **dadurch gekennzeichnet,**

   - **dass** geprüft wird, ob eine Stromwandlersättigung bezüglich zumindest eines zur Bildung des Nullstroms herangezogenen Phasenleiterstrommesswerts aufgetreten ist, und
   - **dass** im Falle einer Stromwandlersättigung das Erzeugen des Anregesignals (Sa) unterdrückt wird, sofern ausschließlich das Überschreiten des Nullstrom-Schwellenwerts durch den Nullstrom das Anregesignal (Sa) auslösen würde.

7. Verfahren nach Anspruch 6,
   **dadurch gekennzeichnet,**

   - **dass** der vorgegebene Nullstrom-Schwellenwert eine variable Größe ist, die in Abhängigkeit von der Größe der Phasenstrommesswerte adaptiv verändert wird.

8. Verfahren nach Anspruch 7,
   **dadurch gekennzeichnet,**

   - **dass** der vorgegebene Nullstrom-Schwellenwert umso größer eingestellt wird, je größer die Phasenstrommesswerte sind.

9. Verfahren nach einem der vorangehenden Ansprüche 7-8,
   **dadurch gekennzeichnet,**

   - **dass** der Nullstrom-Schwellenwert durch eine mathematische Funktion definiert wird, bei der die gemessenen Phasenstrommesswerte Parameter bilden.

**Claims**

1. Method for monitoring a three-phase power transmission system (40) which is resonant-earthed or is isolated from earth potential for the presence of an earth fault, in which once a single-phase earth fault has been detected, first a blocking signal is generated for a predetermined period of time (T), which blocking signal blocks any output of a fault signal indicating the single-phase earth fault for this period of time, **characterized**

- **in that** a check is performed to ascertain whether the line-to-line phase voltages of the power transmission system (40) relative to one another exceed a predetermined amplitude-related imbalance threshold,
- **in that** a corresponding balance signal (Ssy) is formed which indicates a balance or imbalance in the line-to-line phase voltages, and
- **in that** this balance signal (Ssy) is used in the further monitoring for the presence of an earth fault.

2. Method according to Claim 1,
 **characterized**

- **in that** blocking of the output of the fault signal is only performed when the line-to-line phase voltages fall below the predetermined imbalance threshold.

3. Method according to Claim 1 or 2,
 **characterized**

- **in that** a check is performed to ascertain whether the zero voltage (3U0) of the power transmission system (40) exceeds a predetermined zero voltage threshold value (U0min), and
- **in that** a trigger signal (Sa, S1) is generated if the zero voltage exceeds the zero voltage threshold value and the line-to-line phase voltages exceed the imbalance threshold.

4. Method according to Claim 3,
 **characterized**

- **in that** the zero current (3I0) is measured and the trigger signal (Sa) is additionally also generated when the zero current (3I0) exceeds a predetermined zero current threshold value.

5. Method according to one of Claims 1 to 4,
 **characterized**

- **in that** the amplitudes of the three line-to-line phase Voltages are determined, and in that the predetermined amplitude-related imbalance threshold is considered as having been exceeded if the difference between the greatest amplitude (Amax) and the smallest amplitude (Amin) exceeds a predetermined differential threshold.

6. Method according to one of the preceding Claims 4 - 5,

**characterized**

- **in that** a check is performed to ascertain whether current transformer saturation has occurred with respect to at least one phase conductor measurement value used for forming the zero current, and
- **in that**, in the event of current transformer saturation, the generation of the trigger signal (Sa) is suppressed if only the event of the zero current threshold value being exceeded by the zero current would activate the trigger signal (Sa).

7. Method according to Claim 6,
 **characterized**

- **in that** the predetermined zero current threshold value is a variable quantity, which changes adaptively as a function of the magnitude of the phase current measurement values.

8. Method according to Claim 7,
 **characterized**

- **in that** the greater the phase current measurement values are, the greater the predetermined zero current threshold value is said to be.

9. Method according to one of the preceding Claims 7 - 8,
 **characterized**

- **in that** the zero current threshold value is defined by a mathematical function, in which the measured phase current measurement values form parameters.

**Revendications**

1. Procédé de contrôle de la présence d'un défaut à la terre sur un réseau ( 40 ) de distribution électrique triphasé compensé ou isolé par rapport au potentiel de terre, dans lequel, après la détection d'un défaut à la terre monophasé pendant une durée ( T ) prescrite, on produit d'abord un signal d'arrêt, qui bloque pendant cette durée une émission d'un signal de défaut indiquant le défaut à la terre monophasé,
 **caractérisé**

- **en ce que** l'on contrôle si les tensions de phases interconnectées du réseau ( 40 ) de distribution électrique dépassent les unes par rapport aux autres un seuil de dissymétrie prescrit rapporté en amplitude,
- **en ce que** l'on forme un signal ( Ssy ) correspondant de symétrie, qui indique une symétrie ou une dissymétrie des tensions de phases interconnectées et

- **en ce que** l'on tire partie de ce signal ( Ssy ) de symétrie lors du contrôle ultérieur de la présence d'un défaut à la terre.

2. Procédé suivant la revendication 1, **caractérisé**

- **en ce que** l'on n'effectue un blocage de l'émission du signal de défaut que si les tensions de phase interconnectées sont inférieures au seuil de dissymétrie prescrit.

3. Procédé suivant la revendication 1 ou 2, **caractérisé**

- **en ce que** l'on contrôle si la tension ( 3U0 ) homopolaire du réseau ( 40 ) de distribution électrique dépasse une valeur ( U0min ) de seuil de tension homopolaire prescrite et

- **en ce que** l'on produit un signal ( Sa, S1 ) d'excitation, si la tension homopolaire dépasse la valeur de seuil de tension homopolaire et si les tensions de phase interconnectées dépassent le seuil de symétrie.

4. Procédé suivant la revendication 3, **caractérisé**

- **en ce que** l'on mesure le courant ( 310 ) homopolaire et l'on produit également supplémentairement le signal ( Sa ) d'excitation si le courant ( 310 ) homopolaire dépasse une valeur de seuil prescrite de courant homopolaire.

5. Procédé suivant l'une quelconque des revendications 1 à 4, **caractérisé**

- **en ce que** l'on détermine les amplitudes des trois tensions de phase interconnectées et en ce que l'on considère que le seuil de dissymétrie prescrit rapporté en amplitude est dépassé si la différence entre l'amplitude ( Amax ) la plus grande et l'amplitude ( Amin ) la plus petite dépasse un seuil de différence prescrit.

6. Procédé suivant l'une quelconque des revendications 4 à 5, **caractérisé**

- **en ce que** l'on contrôle s'il s'est produit une saturation de transformateur de courant en ce qui concerne au moins une valeur de courant du fil de phase mis à profit pour la formation du courant homopolaire et

- **en ce que**, dans le cas d'une saturation de transformateur de courant, on supprime la production du signal ( Sa ) d'excitation pour autant que le dépassement de la valeur de seuil de courant homopolaire par le courant homopolaire déclencherait exclusivement le signal ( Sa ) d'excitation.

7. Procédé suivant la revendication 6, **caractérisé**

- **en ce que** la valeur de seuil prescrite de courant homopolaire est une valeur variable que l'on modifie de manière adaptative en fonction des valeurs de mesure de courant de phase.

8. Procédé suivant la revendication 7, **caractérisé**

- **en ce que** l'on règle la valeur de seuil prescrite de courant homopolaire à une valeur d'autant plus grande que les valeurs de courant de phase mesurées sont plus grandes.

9. Procédé suivant l'une des revendications 7 à 8, **caractérisé**

- **en ce que** l'on définit la valeur de seuil de courant homopolaire par une fonction mathématique dans laquelle les valeurs mesurées de courant de phase forment des paramètres.

# FIG 1

EP 2 226 913 B1

## FIG 2

## FIG 3

FIG 4

# FIG 5

# FIG 6

# FIG 7

# FIG 8

Normalbetrieb, fehlerfrei     Einfach-Erdschluß L2-E     Einfach-Erdschluß L1-E und L2-E

Spannungszeiger
Leiter-Erde

Spannungszeiger
Leiter-Leiter

EP 2 226 913 B1

FIG 9

**EP 2 226 913 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- JP 2004015862 A